(19) Europäisches Patentamt
European Patent Office
Office européen des brevets

(11)     **EP 3 155 376 B1**

(12)     **FASCICULE DE BREVET EUROPEEN**

(45) Date de publication et mention
de la délivrance du brevet:
**01.08.2018   Bulletin 2018/31**

(21) Numéro de dépôt: **15731862.7**

(22) Date de dépôt: **10.06.2015**

(51) Int Cl.:
***G01D 5/24*** *(2006.01)*

(86) Numéro de dépôt international:
**PCT/EP2015/062875**

(87) Numéro de publication internationale:
**WO 2015/189232 (17.12.2015 Gazette 2015/50)**

(54) **PROCEDE DE SUIVI TEMPS REEL DE L'ETAT DE FONCTIONNEMENT D'UN CAPTEUR CAPACITIF**

VERFAHREN ZUR ECHTZEITVERFOLGUNG DES BETRIEBSZUSTANDES EINES KAPAZITIVEN SENSORS

METHOD FOR REAL-TIME TRACKING OF THE OPERATIONAL STATUS OF A CAPACITIVE SENSOR

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité:  **13.06.2014   FR 1455403**

(43) Date de publication de la demande:
**19.04.2017   Bulletin 2017/16**

(73) Titulaire: **Fogale Nanotech
30900 Nimes (FR)**

(72) Inventeurs:
• **NEEL, Christian**
**F-30900 Nîmes (FR)**
• **BILLIARD, Nicolas**
**F-30900 Nîmes (FR)**

(74) Mandataire: **Pontet Allano & Associes
Parc Les Algorithmes, Bâtiment Platon
CS 70003 Saint-Aubin
91192 Gif-sur-Yvette Cedex (FR)**

(56) Documents cités:
DE-A1-102007 028 335     FR-A1- 2 784 179
FR-A1- 2 912 814

**Description**

La présente invention se rapporte à un procédé de suivi de l'état de fonctionnement d'un capteur capacitif. Elle trouve une application particulièrement intéressante, mais pas uniquement, dans la mesure des passages d'aubes dans une machine tournante ou une turbomachine telle qu'un turboréacteur ou un turbopropulseur d'avion, ou une turbine de générateur électrique par exemple. L'invention est d'un cadre plus large puisqu'elle peut s'appliquer à tout système utilisant un capteur capacitif dans des conditions environnementales très difficiles.

Lors du fonctionnement de la turbomachine, il est connu de monter un capteur capacitif sur le carter. Le document US2010268509 décrit une électrode constituée par le rotor et une contre-électrode constituée par le carter, en particulier la couche interne du carter notamment constituée de plusieurs feuilles.

D'une façon générale, il est possible de mesurer en temps réel de manière non intrusive dans une machine tournante ou une turbomachine les passages des aubes pour en extraire le jeu entre le carter et la tête de l'aube ainsi que les vibrations de l'aube. Ces deux informations, le jeu et les vibrations, sont des informations clés sur l'état de vie de l'aube, c'est à dire son intégrité mécanique. Elles peuvent être suivies en temps réel sur toute la durée de fonctionnement de la machine, notamment d'une surveillance de l'état des aubes (BHM pour « Blade Health Monitoring »).

Il est connu que les mesures capacitives dans ces conditions sont fortement affectées par les pertes électriques de ligne, dues à l'impédance électrique de la ligne de transmission.

On connaît le document JP2006170797 décrivant un principe de compensation des éléments parasites de la ligne de transmission.

Le document FR2784179 décrit un système de compensation des courants de fuite de la ligne de transmission en réalisant des boucles de contre réaction à partir de signaux représentatifs de la compensation en capacité et en conductance.

Cependant, tout comme son environnement, carter moteur, aube, cheminement, le capteur non-intrusif utilisé pour la mesure de jeu et de vibrations évolue dans le temps en fonction des charges thermiques et mécaniques qui s'appliquent sur lui en fonctionnement.

La présente invention a pour but le suivi en temps réel de l'état du capteur.

La présente invention a aussi pour but de réaliser des diagnostics sur des risques de réalisation de mesures non fiables.

On atteint au moins l'un des objectifs avec un procédé de suivi temps réel de l'état de fonctionnement d'un capteur capacitif apte à être monté sur une machine tournante, et relié à un module électronique de mesure via une ligne de transmission à haute fréquence.

Selon l'invention, ce procédé comprend les étapes de :

- génération au sein du module électronique d'un signal de compensation en capacité d'effets parasites de la ligne de transmission et du capteur,
- génération au sein du module électronique d'un signal de compensation en conductance d'effets parasites de la ligne de transmission et du capteur,
- prélèvement d'un signal représentatif de la compensation en capacité et d'un signal représentatif de la compensation en conductance de façon à déterminer un point de fonctionnement du capteur,
- analyse du point de fonctionnement de façon à vérifier s'il se trouve dans une zone prédéterminée.

Selon les modes d'implémentation, la zone prédéterminée peut être plus large que, ou moins large que, ou similaire à, une zone de fonctionnement normal liée à la température.

La machine tournante peut comprendre, notamment, une turbomachine telle qu'un turboréacteur ou un turbopropulseur d'avion, ou une turbine de générateur électrique.

Avec le procédé selon l'invention, on assure un suivi temps-réel de l'état de vie du capteur capacitif qui peut ainsi être complètement intégré dans une gestion globale optimisée de la chaîne de mesure.

On utilise avantageusement une technologie dite active dans la mesure où le module électronique met en oeuvre une conversion du signal physique en signal analogique ainsi que des compensations en capacité et en conductance des effets parasites de la chaîne de mesure.

L'invention est particulièrement astucieuse, mais pas uniquement, par le fait qu'on utilise les signaux de compensation comme paramètres de suivi de l'état de vie du capteur au-delà de la simple vérification de sa température. En effet un tel capteur baigne dans un environnement très hostile lié à des températures élevées, à la variation de ces températures, mais également à l'humidité et à d'autres polluants.

Alors que les signaux de compensation sont généralement utilisés que pour la compensation, la présente invention profite de leur présence pour élaborer une politique de surveillance et de diagnostic. Pour ce faire, on considère l'espace des valeurs de capacité et de conductance de compensation, c'est-à-dire un espace bidimensionnel ayant en abscisse et en ordonnée les valeurs de capacité et de conductance, ou inversement. On détermine ensuite une zone de tolérance dite zone prédéterminée dans laquelle le capteur est opérationnel. En dehors de cette zone prédéterminée, on estime que le capteur est en défaut pour diverses raisons. Un point de fonctionnement est un point dans l'espace des valeurs de compensation. Il est connu que le point de fonctionnement suit une évolution en fonction de la température. On prévoit que la zone prédéterminée soit de préférence strictement plus large que la courbe d'évolution fonction de la température. Cela signifie que l'on tient compte d'autres éléments de défaillance en plus de la température.

Selon une caractéristique avantageuse de l'invention, le procédé peut comprendre également une étape de déclenchement d'un signal d'alarme lorsque le point de fonctionnement est en dehors de la zone prédéterminée. Il peut s'agir d'une vérification tout ou rien permettant d'avertir un opérateur que le point de fonctionnement courant est obtenu avec un capteur non opérationnel.

Avantageusement, le procédé selon l'invention peut comprendre une étape d'analyse de l'évolution du point de fonctionnement afin d'en déduire un diagnostic. Cette évolution peut se concrétiser par une trajectoire et/ou une vitesse et/ou une accélération.

Avec la présente invention, le point de fonctionnement est analysé. Mais on analyse également son évolution au cours du temps de façon à en déduire un certain nombre d'enseignements tels que par exemple le type de défaut ou de risque comme on le verra ci-après. En suivant l'évolution dans le temps des compensations, il est possible de faire un diagnostic de l'état de vie du capteur au cours de son utilisation. Dans le cas de la mesure capacitive, cela peut se faire en suivant l'évolution de la compensation en conductance et en capacité

Selon un mode de mise en oeuvre avantageux de l'invention, la zone prédéterminée est définie à partir de valeurs limites de température du capteur et/ou de la ligne de transmission, et de valeurs limites de capacité et de conductance représentatives d'au moins l'un des paramètres suivants : court-circuit d'électrodes du capteur, rupture ou court-circuit de la liaison entre le module électronique et le capteur, fissure d'une céramique contenue dans le capteur.

Ainsi l'élaboration de la zone prédéterminée se fait à partir de nombreux paramètres obtenus par expérience ou par calcul à partir des résistances et capacités parasites de la chaîne de mesure. Ces paramètres sont directement liés au capteur.

En complément notamment de ce qui précède, la zone prédéterminée peut en outre être définie à partir de valeurs limites de capacité et de conductance représentatives d'au moins l'un des paramètres suivants de la ligne de transmission : rupture de moyens de connexion à la masse, rupture de moyens de connexion à une garde. Ces paramètres sont directement liés à la ligne de transmission. On peut ainsi diagnostiquer des défaillances dues à la ligne de transmission ou au capteur, et quel type de défaillance.

A titre d'exemple non limitatif, plusieurs paramètres et leur influence dans la détermination de la zone prédéterminée peuvent être cités.

On détermine par exemple un facteur de risque lié au court-circuit d'électrodes du capteur lorsque le point de fonctionnement tend vers des valeurs de conductance et de capacité de saturation. Il est donc relativement aisé de déduire un risque d'évolution vers un défaut de court-circuit en analysant le fait que le point de fonctionnement évolue vers des valeurs maximales de la capacité et de la conductance.

On peut également déterminer un facteur de risque lié à une fissure céramique du capteur lorsque le point de fonctionnement évolue vers des valeurs de conductance de plus en plus élevées. Une forte variation de la valeur de conductance indépendamment de la variation de la valeur de capacité peut ainsi présager d'une fragilisation de la céramique constituant le capteur.

On peut également déterminer un facteur de risque lié à une température élevée du capteur lorsque le point de fonctionnement évolue vers des valeurs de conductance et de capacité de plus en plus élevées.

On peut également déterminer un facteur de risque lié à une température élevée de la ligne de transmission lorsque le point de fonctionnement évolue vers des valeurs de conductance négatives de plus en plus élevées en valeur absolue et des valeurs de capacité positives de plus en plus élevées.

On peut enfin par exemple déterminer un facteur de risque lié à une rupture de moyens de connexion à la masse de la ligne de transmission lorsque le point de fonctionnement évolue vers des valeurs de conductance et de capacité de plus en plus faibles.

Les moyens de connexions à la masse peuvent tout simplement être des connecteurs reliés à la masse.

On peut encore déterminer un facteur de risque lié à une rupture de moyens de connexion à une garde de la ligne de transmission lorsque le point de fonctionnement évolue vers des valeurs de capacité de plus en plus élevées.

Selon un mode de mise en oeuvre avantageux de l'invention, chaque mesure réalisée par le capteur capacitif peut être accompagnée de la détermination dudit point de fonctionnement ; la mesure étant validée uniquement lorsque le point de fonctionnement est à l'intérieur de la zone prédéterminée. Il s'agit d'un processus de surveillance qui peut être automatique de sorte que seules les mesures réalisées dans de bonnes conditions sont prises en compte.

De préférence, on prévoit une étape d'émission d'un signal sonore et/ou visuel lorsque le point de fonctionnement est en dehors de la zone prédéterminée.

L'invention prévoit également l'utilisation du procédé tel que décrit ci-dessous, pour la mesure du temps de passage des sommets d'aubes dans une machine tournante.

Il est également prévu une chaîne de mesure capacitive comprenant :

- un capteur capacitif apte à être monté sur une machine tournante,
- un module électronique de mesure, et
- une ligne de transmission à haute fréquence reliant le capteur au module électronique.

Selon l'invention, le module électronique est configuré pour réaliser un suivi temps réel de l'état de fonctionnement du capteur par les étapes de :

- génération d'un signal de compensation en capacité d'effets parasites de la ligne de transmission et du capteur,
- génération d'un signal de compensation en conductance d'effets parasites de la ligne de transmission et du capteur,
- prélèvement d'un signal représentatif de la compensation en capacité et d'un signal représentatif de la compensation en conductance de façon à déterminer un point de fonctionnement du capteur,
- analyse du point de fonctionnement de façon à vérifier s'il se trouve en dehors d'une zone prédéterminée.

Selon une caractéristique avantageuse de l'invention, la ligne de transmission peut comprend un câble triaxial ou coaxial.
Selon une caractéristique avantageuse de l'invention, la chaîne de mesure capacitive peut comprendre un capteur capacitif de type triaxial, ou coaxial.
D'autres avantages et caractéristiques de l'invention apparaîtront à l'examen de la description détaillée d'un mode de mise en oeuvre nullement limitatif, et des dessins annexés, sur lesquels :

- La Fig. 1 est une vue schématique d'un exemple de chaîne de mesure active adaptée à la mise en oeuvre de l'invention,
- La Fig. 2 est une vue schématique simplifiée de l'intégration du procédé de diagnostic selon l'invention dans une chaîne de mesure active,
- La Fig. 3 est une courbe illustrant la zone prédéterminée pour un capteur coaxial, et
- La Fig. 4 est une courbe illustrant la zone prédéterminée pour un capteur triaxial.

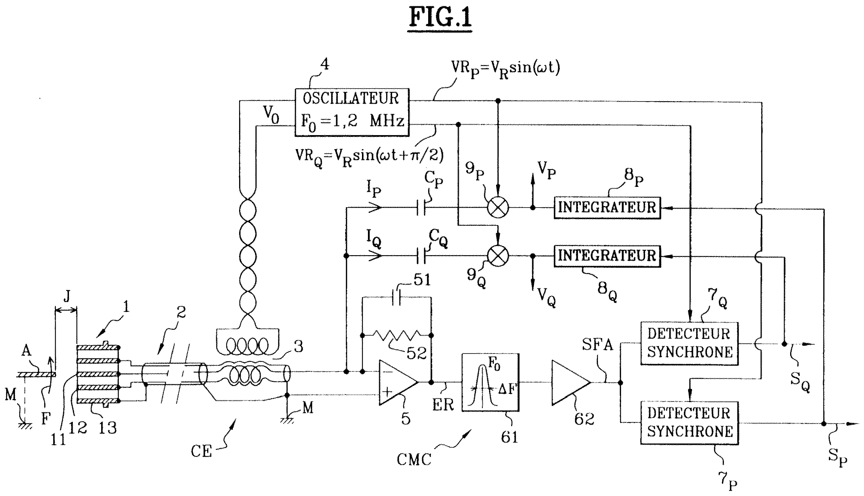

Bien que l'invention n'y soit pas limitée, on va maintenant décrire une chaîne de mesure comprenant un capteur capacitif monté sur un carter d'une turbomachine pour la mesure de temps de passage des sommets d'aubes. Les sollicitations aérodynamiques, thermiques et mécaniques de la turbomachine en fonctionnement peuvent modifier la fiabilité du capteur, donc fausser les mesures. Dans le cadre d'une surveillance générale de l'état des aubes, il est nécessaire de prendre également en compte l'évolution de l'état du capteur.
On va décrire la mise en oeuvre de l'invention en relation avec un mode de réalisation d'une chaîne de détection capacitive mettant en oeuvre une compensation automatique des capacités et des conductances de fuite telle que décrite dans le document FR2784179.
Bien entendu, l'invention peut être mise en oeuvre avec d'autres modes de réalisation d'une chaîne de détection capacitive qui met en oeuvre une compensation des capacités et des conductances de fuite.
Pour des raisons de clarté et de concision, la Fig. 1 et la description y afférente ci-dessous sont essentiellement reprises de ce document FR2784179.
En référence à la Fig. 1, la chaîne de mesure capacitive comprend un circuit d'entrée CE et un circuit de mesure capacitive CMC.
Le circuit d'entrée CE comprend essentiellement un capteur capacitif 1, une ligne de transmission à haute fréquence de liaison 2 et un transformateur 3 relié à une source de tension à haute fréquence 4.
Dans le mode de réalisation présenté, le capteur capacitif 1 est de type triaxial et comprend des première, deuxième et troisième électrodes concentriques 11, 12 et 13.
La première électrode est une électrode centrale de mesure 11, de l'ordre de quelques millimètres de diamètre par exemple. L'électrode 11 a une extrémité libre qui est disposée en face d'une pièce A reliée à un potentiel de référence tel que la masse M d'un dispositif incluant la pièce A, directement ou par des capacités parasites propres au dispositif. La distance J entre l'extrémité de l'électrode de mesure 11 et la pièce A est à mesurer. Par exemple, la pièce A est constituée successivement par les aubes d'une turbine tournant autour d'un axe perpendiculaire au plan de la Fig. 1, suivant la flèche F. La distance J est le jeu variable, de l'ordre du millimètre, entre les extrémités des aubes A passant successivement devant l'électrode centrale 11.
La variation du jeu J engendre un signal à basse fréquence dont les variations d'amplitude d'une période à la suivante varient peu, chaque période correspondant au passage d'une aube respective. Le signal à basse fréquence module en amplitude une porteuse de fréquence $F_0$ en un signal modulé ayant une amplitude variant en fonction du jeu J. La deuxième électrode 12 entoure la première électrode 11 et constitue une électrode de garde.

La troisième électrode 13 est une électrode de blindage reliée à la masse M et entourant l'électrode 12 et constitue le corps métallique cylindrique du capteur 1. La face avant du corps du capteur est fixée dans un trou du carter de révolution CT, par exemple cylindrique ou conique, de la turbine.

Les valeurs des impédances parasites, tant au niveau du capteur 1 que de la ligne de liaison 2 sont variables avec la température et la chaîne de 1 mesure doit être très tolérante pour ces variations de capacité et de résistance.

La ligne de liaison 2, selon la réalisation illustrée à la Fig. 1, comprend une section de câble triaxial avec trois conducteurs concentriques 21, 22 et 23 respectivement reliés aux électrodes 11, 12 et 13 du capteur 1. En général, le câble de liaison comprend un câble triaxial rigide LTR typiquement de quelques mètres de longueur dont une extrémité est soudée directement au capteur, et un câble triaxial souple LTS dont la longueur peut être de quelques mètres à quelques dizaines de mètres. Le câble de liaison peut comprendre également une section de câble coaxial du côté de l'électronique.

Suivant d'autres modes de réalisation, le capteur capacitif 1 peut être de type coaxial. Dans ce cas il ne comprend qu'une première électrode 11 de mesure et une troisième électrode 13 de blindage reliée à la masse M.

Dans ce cas, la ligne de liaison 2 est un câble coaxial qui comprend deux conducteurs concentriques 21 et 23 respectivement reliés aux électrodes 11 et 13 du capteur coaxial 1.

Une différence importante entre les capteurs coaxiaux et triaxiaux est que les impédances de perte dans les capteurs coaxiaux dépendent plus fortement de la température. Selon les applications, il peut être utile de minimiser cette dépendance, ou au contraire de l'augmenter volontairement.

La source de tension alternative 4 est un oscillateur à haute fréquence HF, piloté par un quartz à une fréquence porteuse $F_0$, et asservi en amplitude de façon à améliorer la forme d'onde de la porteuse générée et à garantir la constance des caractéristiques de la chaîne de mesure. La porteuse, qui est une tension de polarisation sinusoïdale, est appliquée par l'oscillateur 4 au capteur 1 à travers le transformateur 3.

Dans le mode de réalisation présenté, cette porteuse a typiquement une amplitude de l'ordre de quelques volts à 10 volts efficaces, et une fréquence $F_0$ de l'ordre du MHz.

L'oscillateur fournit également deux tensions de référence en phase et en quadrature:

$$VR_P = V_R \sin(\omega t) \text{ et } VR_Q = V_R \sin(\omega t + \pi/2)$$

avec $\omega = 2\pi P_0$ la pulsation de la porteuse HF. Les tensions $VR_P$ et $VR_Q$ sont utilisées pour piloter des détecteurs synchrones et générer des signaux de tension de compensation active nécessaires au fonctionnement du circuit de mesure capacitive CMC.

Dans le circuit d'entrée CE, le transformateur 3 présente un primaire relié à des bornes de sortie de l'oscillateur 4 produisant la porteuse $V_0 \sin(\omega t)$ de fréquence $F_0$ et un secondaire, constituant une source flottante, relié d'une part au capteur 1 à travers la ligne de liaison 2 et d'autre part aux entrées d'un amplificateur de charge 5 inclus dans le circuit de mesure CMC. Comme on le verra dans la suite, la ligne de liaison peut être du type triaxial ou bifilaire blindé, ou coaxial; un conducteur de la ligne de liaison relie l'électrode de mesure 11 à l'entrée inverseuse (-) de l'amplificateur 5 à travers le secondaire du transformateur 3. Un conducteur de blindage de la ligne de liaison relie au moins l'électrode de blindage 13 du capteur 1 à la borne de masse M.

L'amplificateur de charge 5 est un amplificateur opérationnel 30 dont la sortie est reliée en contre-réaction à l'entrée inverseuse (-) à travers un condensateur de contre-réaction 51 de capacité C51 et une résistance de contre-réaction 52 en parallèle, et à travers une boucle d'asservissement de phase décrite ci-après.

La boucle d'asservissement comprend un filtre passe-bande 61 et un amplificateur 62 connectés en cascade à la sortie de l'amplificateur de charge 5, ainsi que deux voies parallèles entre la sortie de l'amplificateur 62 et l'entrée inverseuse (-) de l'amplificateur de charge 5. Les voies sont assignées à des traitements de signaux en phase (P) et en quadrature (Q). Chaque voie comprend en cascade un détecteur synchrone $7_P$, $7_Q$, un intégrateur $8_P$, $8_Q$, un multiplieur $9_P$, $9_Q$ et un condensateur de référence $C_P$, $C_Q$ de capacité de référence $C_R$.

La voie comprenant le détecteur synchrone $7_P$, l'intégrateur $8_P$, le multiplieur $9_P$ et le condensateur de référence $C_P$ permet de compenser la partie réactive de l'impédance de perte du capteur 1 et de la ligne de liaison 2.

La voie comprenant le détecteur synchrone $7_Q$, l'intégrateur $8_Q$, le multiplieur $9_Q$ et le condensateur de référence $C_Q$ permet de compenser la partie résistive de l'impédance de perte du capteur 1 et de la ligne de liaison 2.

Cette impédance de perte peut être modélisée globalement comme une capacité et une résistance parasites en parallèle entre l'entrée inverseuse (-) de l'amplificateur de charge 5 et la masse M.

La bande passante AF du filtre 61 est centrée sur la fréquence $F_0$ de l'oscillateur 4 et a une largeur fixée typiquement à 300 kHz environ. L'amplificateur 62 est un amplificateur-suiveur de gain unitaire et produit un signal de tension filtré et amplifié SFA dont l'amplitude varie inversement avec le jeu J dans le capteur 1. Ce signal est appliqué aux deux détecteurs synchrones $7_P$ et $7_Q$ qui sont pilotés par les tensions de référence en phase et quadrature $VR_P$ et

$VR_Q$ fournies par l'oscillateur 4. Les détecteurs synchrones $7_P$ et $7_Q$ sont des détecteurs de phase qui démodulent en amplitude le signal de tension filtré et amplifié SFA en deux signaux composants en phase et en quadrature $S_P$ et $S_Q$ dont l'un d'eux, $S_P$, est exploité pour mesurer le jeu J. Les signaux composants à basse fréquence $S_P$ et $S_Q$ sont respectivement intégrés dans les intégrateurs $8_P$ et $8_Q$ en une tension en phase $V_P$ et une tension en quadrature $V_Q$ afin de stabiliser la boucle d'asservissement. Les tensions $V_P$ et $V_Q$ sortant des intégrateurs sont appliquées à des premières entrées des deux multiplieurs $9_P$ et $9_Q$ de facteur de multiplication K de façon à multiplier les tensions $V_P$ et $V_Q$ respectivement par les tensions de référence $VR_P = V_R \sin(2\omega t)$ et $VR_Q = V_R \sin(2\omega t + \pi/2)$ appliquées à des deuxièmes entrées des multiplieurs.

Les signaux modulés en amplitude [$K V_P V_R \sin(2\omega t)$] et [$K V_Q V_R \sin(2\omega t + \pi/2)$] produits par les multiplieurs $9_P$ et $9_Q$ sont réinjectés à l'entrée inverseuse (-) de l'amplificateur de charge 5 via les condensateurs de référence $C_P$ et $C_Q$ avec des phases convenables et additionnés au signal de mesure transmis par le capteur 1 via le transformateur 3 afin d'obtenir la stabilité de l'asservissement.

Compte tenu du facteur d'amplification très grand aux basses fréquences assuré par les intégrateurs, la valeur moyenne du signal d'erreur ER en sortie de l'amplificateur 5 et donc les valeurs moyennes des signaux $S_P$ et $S_Q$ sont maintenues nulles.

Le courant en phase traversant le capteur 1 et ayant pour amplitude ($V_0 C_{13}\omega$) est compensé par le courant traversant le condensateur de phase Cp, ayant l'amplitude:

$$Ip = K \, Vp \, V_R \, C_R\omega.$$

Le courant en quadrature dû aux pertes du capteur et ayant pour amplitude $V_0/R_{13}$ est compensé par un courant traversant le condensateur de quadrature CQ, ayant l'amplitude:

$$I_Q = K \, V_Q \, V_R \, C_R\omega.$$

Le condensateur $C_Q$ alimenté par le courant en quadrature se comporte comme une résistance alimentée avec un courant en phase. Il permet ainsi une compensation des pertes résistives, mais en évitant le bruit thermique qui serait introduit par l'utilisation d'une résistance.

Les sensibilités nominales aux sorties des intégrateurs $I_P$ et $I_Q$ sont:

$$S(V_P) = \frac{V_P}{C_{13}} = \frac{V_0}{KV_R}\frac{1}{C_R} \quad \text{V/pF,}$$

et

$$S(V_Q) = \frac{V_Q}{1/R_{13}} = \frac{V_0}{KV_R}\frac{1}{C_R\omega} \quad \text{V/Siemens.}$$

A la sortie de l'amplificateur 5, le signal d'erreur ER est normalement nul lorsque la pièce A est immobile. En fonctionnement, lorsque la turbine tourne, le signal ER ne comprend que le bruit de fond du capteur capacitif 1, ainsi que des signaux transitoires, par exemple le passage d'une aube A, qui sont dans la bande passante limitée AF de l'asservissement.

Le signal $S_P$ (ou $S_Q$) de passage d'une aube se présente à la sortie de la chaîne de mesure de jeu sous la forme d'un signal à valeur moyenne nulle.

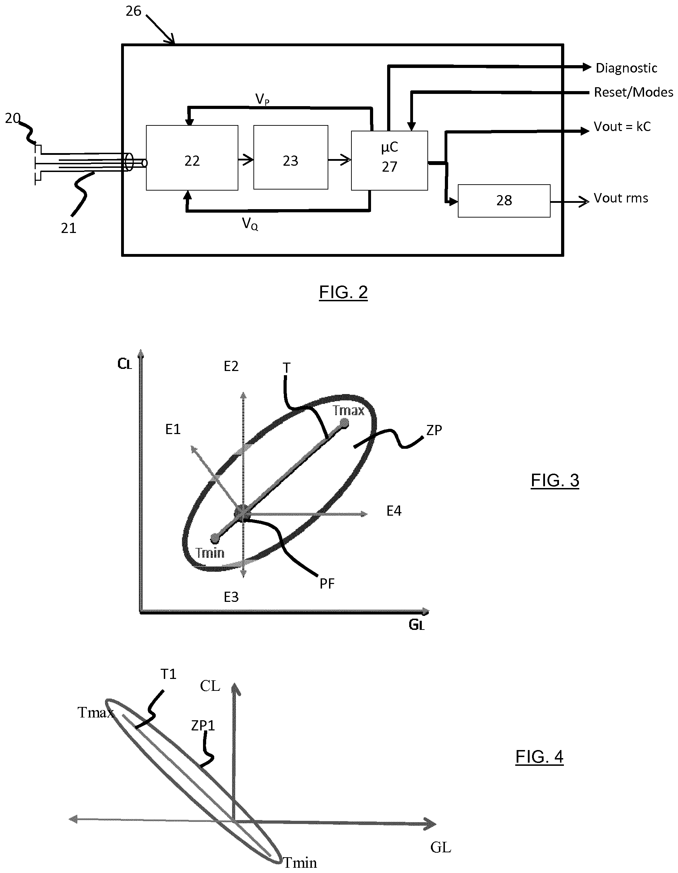

Le schéma simplifié de la Fig. 2 est une représentation fonctionnelle d'une chaîne de mesure et de traitement implémentant le procédé selon l'invention. Dans le mode de réalisation présenté, elle comprend un module électronique 26 intégrant les éléments électroniques de la Fig. 1. Selon l'invention, le module électronique 26 comprend en outre une unité de traitement de signal 24 apte à mettre en oeuvre le procédé selon l'invention.

Le capteur 20 est disposé à l'extrémité d'une ligne de transmission 21 constituée par un câble triaxial. Dans le mode de réalisation présenté, le capteur 20 est un capteur coaxial, dont les électrodes sont reliées respectivement au conducteur de mesure et au conducteur de masse du câble. D'autres câbles peuvent bien entendu être utilisés tels que notamment un câble coaxial.

L'entrée du module électronique 26 est assurée par le préamplificateur 22 comprenant notamment l'amplificateur de charge 5 de la Fig. 1. Des signaux de compensation en conductance et en capacité sont générés par l'unité de traitement de signal 24 et sont injectés dans le préamplificateur 22. Un amplificateur 23, intégrant notamment l'amplificateur 6 de la Fig. 1, alimente, après amplification, l'unité de traitement de signal 24 à partir d'un signal provenant du préamplificateur 22. L'unité de traitement 24 comprend avantageusement les détecteurs synchrones et les intégrateurs de la Fig. 1 ainsi qu'un microcontrôleur 27 configuré pour mettre en oeuvre le procédé selon l'invention. Ce microcontrôleur 27 reçoit les signaux VQ et VP, puis en déduit des valeurs de conductance et de capacité sachant que VQ est proportionnel à la conductance que l'on peut nommer $G_L$, et VP est proportionnel à la capacité que l'on peut nommer $C_L$.

L'unité de traitement de signal 24 est apte à générer un signal de sortie Vout qui est proportionnel à la capacité mesurée par le capteur 20, Vout=kC, k étant un nombre réel. Ce signal de sortie peut alimenter un convertisseur RMS/DC 28.

Le microcontrôleur est configuré pour déterminer en temps réel les valeurs de $G_L$ et $C_L$ et enregistrer ces valeurs en mémoire de façon à avoir un suivi de leurs évolutions. Une valeur $G_L$ associé à une valeur $C_L$ constitue un point de fonctionnement qui peut être représenté dans un espace à deux dimensions ayant pour axe des abscisses, les valeurs de $C_L$, et pour axe des ordonnées les valeurs de $G_L$.

Sur la Fig. 3 sont illustrées des courbes représentatives des variations du point de fonctionnement dans un repère $G_L/C_L$ pour un capteur coaxial.

On distingue une première courbe T sous la forme d'un segment oblique dans le domaine des valeurs positives de conductance et de capacité.

Dans un état de vie dit normal, en fonction de la variation de paramètres environnementaux tels que la température, la compensation de ligne, représentée par la capacitance $C_L$ et la conductance $G_L$, reste dans ou à proximité de la courbe T prédéterminée, et la capacitance $C_L$ et la conductance $G_L$ suivent une évolution monotone l'une par rapport à l'autre (par exemple la conductance croît lorsque la capacité croît).

En cas de défaillance du capteur ou du câble, le point de fonctionnement matérialisé par la capacitance $C_L$ et la conductance $G_L$ s'éloigne de la courbe T de fonctionnement dit normal. La détection de l'évolution de ces paramètres à distance de la courbe de fonctionnement normal permet de détecter des défaillances et/ou d'invalider des mesures, dans le cadre par exemple d'une surveillance de l'état de pâle (BHM pour « blade health monitoring »).

Dans des conditions normales, le point de fonctionnement courant PF peut évoluer sur la courbe T entre un point inférieur correspondant à une température Tmin et un point supérieur correspondant à une température Tmax.

Selon l'invention, pour détecter les défaillances et les risques, on peut définir préalablement une courbe définissant une zone prédéterminée ZP. Cette zone prédéterminée englobe la courbe T. On peut ainsi mettre en oeuvre la méthode de détection suivante :

- lorsque le point de fonctionnement n'est plus sur la courbe T mais à l'intérieur de la zone prédéterminée, on estime qu'il y a un risque sur l'état de fonctionnement du capteur et qu'il est nécessaire de suivre l'évolution ;
- Au-delà de la zone prédéterminée, on estime que la mesure n'est pas fiable.

La Fig. 3 présente des flèches E1-E4 qui partent du point de fonctionnement vers des directions différentes. Chaque flèche représente une évolution risquée due à une ou plusieurs caractéristiques prédéfinies.

Par exemple, l'évolution dans la direction de la flèche E1 (la capacité croît lorsque la conductance diminue) est caractéristique d'une évolution vers une coupure de la ligne de transmission.

L'évolution dans la direction de la flèche E2 (augmentation de la capacité pour une valeur fixe de la conductance) est caractéristique d'une évolution vers une rupture d'une connectique de garde de la ligne de transmission.

L'évolution dans la direction de la flèche E3 (baisse de la capacité pour une valeur fixe de la conductance) est caractéristique d'une évolution vers une rupture de l'électrode du capteur.

L'évolution dans la direction de la flèche E4 (augmentation de la conductance pour une valeur fixe de la capacité) est caractéristique d'une évolution vers un court-circuit au niveau du capteur ou de la ligne de transmission.

Sur la Fig. 4 on voit une courbe T1 de fonctionnement normal dans une zone prédéterminée ZP1 pour un capteur triaxial. Dans ce cas, la courbe T1 est une courbe passant par zéro et ayant un minimum (correspondant à une valeur de température Tmin) dans le cadran des conductances positives et des capacités négatives. Le maximum (correspondant à une valeur de température Tmax) se trouve dans le cadran des conductances négatives et des capacités positives.

Comme expliqué précédemment, la présente invention permet de réaliser différents diagnostics à partir de l'analyse du point de fonctionnement et de son évolution. Différents cas de figure sont décrits ci-après à titre simplement d'exemples non limitatifs.

Concernant le capteur capacitif :

- une fissure de la céramique qui constitue l'isolant entre les électrodes peut engendrer une absorption d'humidité ou de polluants. Elle se caractérise par des valeurs de conductance de fuite $G_L$ anormalement élevées. Les risques associés sont une oxydation, une pollution définitive, une rupture et donc la destruction du capteur ;

- une température trop élevée provoque une augmentation de la permittivité diélectrique de l'isolant. Elle se caractérise par des valeurs de capacité de fuite $C_L$ et de conductance de fuite $G_L$ anormalement élevées. Les risques associés sont une dégradation irréversible ou une destruction du capteur ;
- une amorce de court-circuit entre l'électrode de mesure et la masse se caractérise par des saturations des tensions de compensation et une surconsommation de l'oscillateur 4 qui excite le transformateur. Le risque est également une destruction du capteur ;
- une rupture de la liaison électrique avec l'électrode de mesure, outre l'absence de signaux de mesure, se caractérise par une diminution de la capacité de fuite $C_L$ due au fait que la capacité de fuite résiduelle ne concerne que la section de la ligne de mesure jusqu'à la rupture.

Concernant le câble, et en particulier un câble triaxial :

- une température trop élevée provoque une augmentation de la permittivité diélectrique de l'isolant (en général minéral). Elle se caractérise par des valeurs de capacité de fuite $C_L$ et de conductance de fuite $G_L$ anormalement élevées en valeur absolue, la conductance de fuite $G_L$ (équivalente) ayant un signe négatif à cause du déphasage introduit par la résistance du câble de garde ;
- une rupture de la connectique des conducteurs de masse se caractérise par des valeurs de capacité de fuite $C_L$ et de conductance de fuite $G_L$ anormalement faibles, puisqu'elles correspondent à une longueur de câble (jusqu'à la rupture) inférieure à la longueur normale ;
- une rupture de la connectique des conducteurs de garde se caractérise par des valeurs de capacité de fuite $C_L$ anormalement élevées, puisqu'elles correspondent à capacité de fuite vers la masse accrue.

Ainsi, on peut noter que l'invention permet de diagnostiquer des causes de défaillance, ou des groupes de causes de défaillances, ou un état anormal, en détectant au moins l'un des évènements suivants :

- une évolution anormale d'un paramètre parmi la capacité de fuite $C_L$ et la conductance de fuite $G_L$, l'autre paramètre conservant une valeur normale ;- une évolution anormale des deux paramètres, la capacité de fuite $C_L$ et la conductance de fuite $G_L$.

Bien entendu, le champ des défaillances possibles ou une identification plus précise de la défaillance peut être réalisée selon l'invention en intégrant dans l'analyse des informations supplémentaires, telles que :

- des mesures de températures externes ;
- la qualité des mesures, ou l'absence de mesures ;
- un suivi de la consommation électrique, afin de détecter notamment des composants saturés.

Bien sûr, l'invention n'est pas limitée aux exemples qui viennent d'être décrits et de nombreux aménagements peuvent être apportés à ces exemples sans sortir du cadre de l'invention.


**Revendications**

1. Procédé de suivi temps réel de l'état de fonctionnement d'un capteur capacitif apte à être monté sur une machine tournante, et relié à un module électronique de mesure via une ligne de transmission à haute fréquence, ce procédé comprenant les étapes de :

   - génération au sein du module électronique d'un signal de compensation en capacité d'effets parasites de la ligne de transmission et du capteur,
   - génération au sein du module électronique d'un signal de compensation en conductance d'effets parasites de la ligne de transmission et du capteur,
   - prélèvement dudit signal représentatif de la compensation en capacité et dudit signal représentatif de la compensation en conductance de façon à déterminer un point de fonctionnement de ladite ligne de transmission et dudit capteur,
   - analyse du point de fonctionnement de façon à vérifier s'il se trouve dans une zone prédéterminée.

2. Procédé selon la revendication 1, **caractérisé en ce qu'**il comprend également une étape de déclenchement d'un

EP 3 155 376 B1

signal d'alarme lorsque le point de fonctionnement est en dehors de la zone prédéterminée.

3. Procédé selon la revendication 1 ou 2, **caractérisé en ce qu'**il comprend une étape d'analyse de l'évolution du point de fonctionnement afin d'en déduire un diagnostic.

4. Procédé selon l'une quelconque des revendications précédentes, **caractérisé en ce que** la zone prédéterminée est définie à partir de valeurs limites de température du capteur et/ou de la ligne de transmission et de valeurs limites de capacité et de conductance représentatives d'au moins l'un des paramètres suivants : court-circuit d'électrodes du capteur, rupture ou court-circuit de la liaison entre le module électronique et le capteur, fissure d'une céramique contenue dans le capteur.

5. Procédé selon la revendication 4, **caractérisé en ce que** la zone prédéterminée est en outre définie à partir de valeurs limites de capacité et de conductance représentatives d'au moins l'un des paramètres suivants de la ligne de transmission : rupture de moyens de connexion à la masse, rupture de moyens de connexion à une garde.

6. Procédé selon l'une des revendications 4 ou 5, **caractérisé en ce qu'**on détermine un facteur de risque lié au court-circuit d'électrodes du capteur lorsque le point de fonctionnement tend vers des valeurs de conductance et de capacité de saturation.

7. Procédé selon l'une quelconque des revendications 4 à 6, **caractérisé en ce qu'**on détermine un facteur de risque lié à une fissure céramique du capteur lorsque le point de fonctionnement évolue vers des valeurs de conductance de plus en plus élevées.

8. Procédé selon l'une quelconque des revendications 4 à 7, **caractérisé en ce qu'**on détermine un facteur de risque lié à une température élevée du capteur lorsque le point de fonctionnement évolue vers des valeurs de conductance et de capacité de plus en plus élevées.

9. Procédé selon l'une quelconque des revendications 5 à 8, **caractérisé en ce qu'**on détermine un facteur de risque lié à une température élevée de la ligne de transmission lorsque le point de fonctionnement évolue vers des valeurs de conductance négatives de plus en plus élevées en valeur absolue et des valeurs de capacité positives de plus en plus élevées.

10. Procédé selon l'une quelconque des revendications 5 à 9, **caractérisé en ce qu'**on détermine un facteur de risque lié à une rupture de moyens de connexion à la masse de la ligne de transmission lorsque le point de fonctionnement évolue vers des valeurs de conductance et de capacité de plus en plus faibles.

11. Procédé selon l'une quelconque des revendications 5 à 10, **caractérisé en ce qu'**on détermine un facteur de risque lié à une rupture de moyens de connexion à une garde de la ligne de transmission lorsque le point de fonctionnement évolue vers des valeurs de capacité de plus en plus élevées.

12. Procédé selon l'une quelconque des revendications précédentes, **caractérisé en ce que** chaque mesure réalisée par le capteur capacitif est accompagnée de la détermination dudit point de fonctionnement ; la mesure étant validée uniquement lorsque le point de fonctionnement est à l'intérieur de la zone prédéterminée.

13. Procédé selon l'une quelconque des revendications précédentes, **caractérisé en ce qu'**il comprend une étape d'émission d'un signal sonore et/ou visuel lorsque le point de fonctionnement est en dehors de la zone prédéterminée.

14. Utilisation du procédé selon l'une quelconque des revendications 1 à 13, pour la mesure du temps de passage des sommets d'aubes dans une machine tournante.

15. Chaîne de mesure capacitive comprenant :

   - un capteur capacitif apte à être monté sur une machine tournante,
   - un module électronique de mesure, et
   - une ligne de transmission à haute fréquence reliant le capteur au module électronique,

   **caractérisée en ce que** le module électronique est configuré pour réaliser un suivi temps réel de l'état de fonctionnement du capteur par les étapes de :

- génération d'un signal de compensation en capacité d'effets parasites de la ligne de transmission et du capteur,
- génération d'un signal de compensation en conductance d'effets parasites de la ligne de transmission et du capteur,
- prélèvement dudit signal représentatif de la compensation en capacité et dudit signal représentatif de la compensation en conductance de façon à déterminer un point de fonctionnement de ladite ligne de transmission et dudit capteur,
- analyse du point de fonctionnement de façon à vérifier s'il se trouve en dehors d'une zone prédéterminée.

**16.** Chaîne de mesure capacitive selon la revendication 15, **caractérisée en ce que** la ligne de transmission comprend un câble triaxial ou coaxial.

**17.** Chaîne de mesure capacitive selon l'une des revendications 15 ou 16, **caractérisée en ce qu'**elle comprend un capteur capacitif de type triaxial, ou coaxial.

**Patentansprüche**

**1.** Verfahren zur Echtzeitüberwachung des Betriebszustands eines kapazitiven Sensors, der geeignet ist, an einer umlaufenden Maschine angebracht zu werden, und der über eine Hochfrequenzübertragungsleitung mit einem elektronischen Messmodul verbunden ist, wobei dieses Verfahren die Schritte umfasst des:

- Erzeugens, innerhalb des elektronischen Moduls, eines Signals einer Kapazitätskompensation von parasitären Effekten der Übertragungsleitung und des Sensors,
- Erzeugens, innerhalb des elektronischen Moduls, eines Signals einer Konduktanzkompensation von parasitären Effekten der Übertragungsleitung und des Sensors,
- Abgreifens des Signals, das für die Kapazitätskompensation repräsentativ ist, und des Signals, das für die Konduktanzkompensation repräsentativ ist, um einen Betriebspunkt der Übertragungsleitung und des Sensors zu bestimmen,
- Analysierens des Betriebspunktes, um zu prüfen, ob er sich in einem vorbestimmten Bereich befindet.

**2.** Verfahren nach Anspruch 1, **dadurch gekennzeichnet, dass** es auch einen Schritt des Auslösens eines Alarmsignals umfasst, wenn der Betriebspunkt außerhalb des vorbestimmten Bereichs liegt.

**3.** Verfahren nach Anspruch 1 oder 2, **dadurch gekennzeichnet, dass** es einen Schritt des Analysierens der Entwicklung des Betriebspunkts umfasst, um daraus eine Diagnose abzuleiten.

**4.** Verfahren nach einem der vorhergehenden Ansprüche, **dadurch gekennzeichnet, dass** der vorbestimmte Bereich anhand von Temperaturgrenzwerten des Sensors und/oder der Übertragungsleitung sowie von Kapazitäts- und Konduktanzgrenzwerten definiert ist, die für wenigstens einen der folgenden Parameter repräsentativ sind: Kurzschluss von Elektroden des Sensors, Unterbrechung oder Kurzschluss der Verbindung zwischen dem elektronischen Modul und dem Sensor, Riss einer in dem Sensor enthaltenen Keramik.

**5.** Verfahren nach Anspruch 4, **dadurch gekennzeichnet, dass** der vorbestimmte Bereich ferner anhand von Kapazitäts- und Konduktanzgrenzwerten definiert ist, die für wenigstens einen der folgenden Parameter der Übertragungsleitung repräsentativ sind: Unterbrechung von Mitteln zum Masseanschluss, Unterbrechung von Mitteln zur Verbindung mit einem Schutz.

**6.** Verfahren nach einem der Ansprüche 4 oder 5, **dadurch gekennzeichnet, dass** ein Risikofaktor, der mit dem Kurzschluss von Elektroden des Sensors verbunden ist, bestimmt wird, wenn der Betriebspunkt zu Sättigungskonduktanz- und - kapazitätswerten hin tendiert.

**7.** Verfahren nach einem der Ansprüche 4 bis 6, **dadurch gekennzeichnet, dass** ein Risikofaktor, der mit einem Keramikriss des Sensors verbunden ist, bestimmt wird, wenn sich der Betriebspunkt zu immer höheren Konduktanzwerten hin entwickelt.

**8.** Verfahren nach einem der Ansprüche 4 bis 7, **dadurch gekennzeichnet, dass** ein Risikofaktor, der mit einer hohen Temperatur des Sensors verbunden ist, bestimmt wird, wenn sich der Betriebspunkt zu immer höheren Konduktanz- und Kapazitätswerten hin entwickelt.

**9.** Verfahren nach einem der Ansprüche 5 bis 8, **dadurch gekennzeichnet, dass** ein Risikofaktor, der mit einer hohen Temperatur der Übertragungsleitung verbunden ist, bestimmt wird, wenn sich der Betriebspunkt zu im Absolutwert immer höheren negativen Konduktanzwerten und zu immer höheren positiven Kapazitätswerten hin entwickelt.

**10.** Verfahren nach einem der Ansprüche 5 bis 9, **dadurch gekennzeichnet, dass** ein Risikofaktor, der mit einer Unterbrechung von Masseanschlussmitteln der Übertragungsleitung verbunden ist, bestimmt wird, wenn sich der Betriebspunkt zu immer geringeren Konduktanz- und Kapazitätswerten hin entwickelt.

**11.** Verfahren nach einem der Ansprüche 5 bis 10, **dadurch gekennzeichnet, dass** ein Risikofaktor, der mit einer Unterbrechung von Mitteln zur Verbindung mit einem Schutz der Übertragungsleitung verbunden ist, bestimmt wird, wenn sich der Betriebspunkt zu immer höheren Kapazitätswerten hin entwickelt.

**12.** Verfahren nach einem der vorhergehenden Ansprüche, **dadurch gekennzeichnet, dass** jede durch den kapazitiven Sensor durchgeführte Messung von der Bestimmung des Betriebspunkts begleitet ist, wobei die Messung nur dann für gültig erklärt wird, wenn sich der Betriebspunkt innerhalb des vorbestimmten Bereichs befindet.

**13.** Verfahren nach einem der vorhergehenden Ansprüche, **dadurch gekennzeichnet, dass** es einen Schritt des Aussendens eines akustischen Signals und/oder Sichtsignals umfasst, wenn der Betriebspunkt außerhalb des vorbestimmten Bereichs liegt.

**14.** Verwendung des Verfahrens nach einem der Ansprüche 1 bis 13, zur Messung der Durchlaufzeit der Schaufelspitzen in einer umlaufenden Maschine.

**15.** Kapazitive Messkette, umfassend:

  - einen kapazitiven Sensor, der geeignet ist, an einer umlaufenden Maschine angebracht zu werden,
  - ein elektronisches Messmodul und
  - eine Hochfrequenzübertragungsleitung, die den Sensor mit dem elektronischen Modul verbindet,

**dadurch gekennzeichnet, dass** das elektronische Modul dazu ausgelegt ist, eine Echtzeitüberwachung des Betriebszustands des Sensors durch die Schritte durchzuführen des:

  - Erzeugens eines Signals einer Kapazitätskompensation von parasitären Effekten der Übertragungsleitung und des Sensors,
  - Erzeugens eines Signals einer Konduktanzkompensation von parasitären Effekten der Übertragungsleitung und des Sensors,
  - Abgreifens des Signals, das für die Kapazitätskompensation repräsentativ ist, und des Signals, das für die Konduktanzkompensation repräsentativ ist, um einen Betriebspunkt der Übertragungsleitung und des Sensors zu bestimmen,
  - Analysierens des Betriebspunktes, um zu prüfen, ob er sich außerhalb eines vorbestimmten Bereichs befindet.

**16.** Kapazitive Messkette nach Anspruch 15, **dadurch gekennzeichnet, dass** die Übertragungsleitung ein Triaxial- oder Koaxialkabel umfasst.

**17.** Kapazitive Messkette nach einem der Ansprüche 15 oder 16, **dadurch gekennzeichnet, dass** sie einen kapazitiven Sensor vom triaxialen oder koaxialen Typ umfasst.


**Claims**

**1.** Method for real-time monitoring the operational state of a capacitive sensor capable of being mounted on a rotating machine, and connected to an electronic measuring module via a high frequency transmission line, this method comprising the steps of:

  - generating within the electronic module a signal for compensating in capacitance parasitic effects from the transmission line and the sensor,
  - generating within the electronic module a signal for compensating in conductance parasitic effects from the transmission line and the sensor,

- extracting said signal representative of the capacitance compensation and said signal representative of the conductance compensation so as to determine an operating point of said transmission line and said sensor,
- analyzing the operating point so as to check if it is located in a predetermined area.

2. Method according to claim 1, **characterized in that** it further comprises a step of triggering an alarm signal when the operating point is outside the predetermined area.

3. Method according to claim 1 or 2, **characterized in that** it comprises a step of analyzing the evolution of the operating point so as to deduce a diagnosis therefrom.

4. Method according to any one of the preceding claims, **characterized in that** the predetermined area is defined on the basis of temperature limit values of the sensor and/or of the transmission line and from capacitance and conductance limit values representative of at least one of the following parameters: short-circuit of electrodes of the sensor, breaking or short-circuit of the connection between the electronic module and the sensor, cracking of a ceramic contained in the sensor.

5. Method according to claim 4, **characterized in that** the predetermined area is further defined on the basis of capacitance and conductance limit values representative of at least one of the following parameters of the transmission line: breaking of the means of connection to the ground, breaking of the means of connection to a guard.

6. Method according to one of claims 4 or 5, **characterized in that** a risk factor related to short-circuit of the electrodes of the sensor when the operating point tends towards saturation conductance and capacitance values is determined.

7. Method according to any one of claims 4 to 6, **characterized in that** a risk factor related to a ceramic cracking of the sensor when the operating point evolves towards higher and higher conductance values is determined.

8. Method according to any one of claims 4 to 7, **characterized in that** a risk factor related to a high temperature of the sensor when the operating point evolves towards higher and higher conductance and capacitance values is determined.

9. Method according to any one of claims 5 to 8, **characterized in that** a risk factor related to a high temperature of the transmission line when the operating point evolves towards higher and higher conductance values in absolute value, and towards higher and higher positive capacitance values is determined.

10. Method according to any one of claims 5 to 9, **characterized in that** a risk factor related to a break in means of connection to the ground of the transmission line when the operating point evolves towards lower and lower conductance and capacitance values is determined.

11. Method according to any one of claims 5 to 10, **characterized in that** a risk factor related to a break in means of connection to a guard of the transmission line when the operating point evolves towards higher and higher capacitance values is determined.

12. Method according to any one of the preceding claims, **characterized in that** each measurement carried out by the capacitive sensor is accompanied by determination of said operating point; the measurement being validated only when the operating point is inside the predetermined area.

13. Method according to any one of the preceding claims, **characterized in that** it comprises a step of transmitting a sound and/or visual signal when the operating point is outside the predetermined area.

14. Use of the method according to any one of claims 1 to 13, for measuring the time taken for the tips of blades to pass in a rotating machine.

15. Capacitive measuring system comprising:

- a capacitive sensor capable of being mounted on a rotating machine,
- an electronic measuring module, and
- a high-frequency transmission line connecting the sensor to the electronic module.

**characterized in that** the electronic module is configured in order to carry out real time monitoring of the operational state of the sensor by the steps of:

- generating a signal for compensating in capacitance parasitic effects from the transmission line and the sensor,
- generating a signal for compensating in conductance parasitic effects from the transmission line and the sensor,
- extracting said signal representative of the capacitance compensation and of said signal representative of the conductance compensation so as to determine an operating point of said transmission line and said sensor,
- analyzing the operating point in order to check if it is outside a predetermined area.

16. Capacitive measuring system according to claim 15, **characterized in that** the transmission line comprises a triaxial or coaxial cable.

17. Capacitive measuring system according to any one of claims 15 or 16, **characterized in that** it comprises a capacitive sensor of the triaxial or coaxial type.

# FIG.1

EP 3 155 376 B1

FIG. 2

FIG. 3

FIG. 4

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2010268509 A
- JP 2006170797 B
- FR 2784179